# EUROPÄISCHE PATENTSCHRIFT

(11) **EP 2 767 658 B1**
(45) Veröffentlichungstag und Bekanntmachung des Hinweises auf die Patenterteilung: **24.05.2017**
(21) Anmeldenummer: 14153875.1
(22) Anmeldetag: 04.02.2014
(51) Int. Cl.: E05B 81/76, H03K 17/955

(54) **Türgriff für ein Kraftfahrzeug**
Door handle for a motor vehicle
Poignée de portière pour véhicule automobile

(30) Priorität: 19.02.2013 DE 102013002750
(43) Veröffentlichungstag der Anmeldung: 20.08.2014
(73) Patentinhaber: Huf Hülsbeck & Fürst GmbH & Co. KG, 42551 Velbert (DE)
(72) Erfinder: Schindler, Mirko, 42549 Velbert (DE); Peschl, Andreas, 42555 Velbert (DE)

(56) Entgegenhaltungen:
- EP-A1- 1 384 845
- EP-A1- 1 510 637
- EP-A1- 1 617 509
- WO-A1-02/33203
- WO-A1-2004/007879
- WO-A1-2008/028839
- WO-A1-2009/112310
- DE-U1-202007 016 121
- FR-A1- 2 828 224
- US-A1- 2003 122 556

## Beschreibung

Die Erfindung betrifft einen Türgriff für ein Kraftfahrzeug mit einem Aufnahmeraum aufweisend einen innerhalb des Aufnahmeraums angeordneten Behälter zur Aufnahme einer Leiterplatte, wobei die Leiterplatte mindestens einen kapazitiven Annäherungssensor zur Erfassung der Annäherung eines Benutzers umfasst, wobei der kapazitive Annährungssensor eine erste Elektrode und ein zweite Elektrode aufweist.
Aus dem Stand der Technik ist ein Türgriff für ein Kraftfahrzeug bekannt, welcher einen Annäherungssensor zur Erfassung der Annäherung einer Person aufweist. Der Annäherungssensor wird gebildet durch eine erste und eine zweite Elektrode, wobei die erste Elektrode auf einer Leiterplatte angeordnet ist. Die zweite Elektrode des Annäherungssensors wird auf die erste Elektrode angelötet. Es hat sich allerdings herausgestellt, dass insbesondere bei hohen Temperaturschwankungen und Erschütterungen die Lötstellen brechen können und somit zum Ausfall der Annäherungssensoren führen. Des Weiteren ist der Lötprozess sehr zeitaufwendig und muss auch sehr präzise durch eine Person oder Maschine durchgeführt werden. Die Kosten zur Herstellung des Türgriffs werden dadurch unnötig erhöht. Nachteilig wirkt sich das Vorhandensein unterschiedlicher Metalle und Legierungen an Lötverbindungen aus. Bei Anwesenheit eines Elektrolyten, beispielsweise Feuchtigkeit, entstehen galvanische Elemente, die zu einer verstärkten Korrosion führen können
Aus der WO2009112310A1 ist ein Türaußengriff bekannt, welcher ein Sensormodul mit einem kapazitiven Sensor aufweist.
Die Aufgabe der Erfindung ist daher, einen kostengünstigen Türgriff bereitzustellen, welcher zuverlässig die Annäherung eines Benutzers erfasst.
Die Aufgabe wird dadurch gelöst, dass zwischen der ersten Elektrode und der zweiten Elektrode des Annäherungssensors ein adhäsiver Stoff zur Verbindung der ersten Elektrode mit der zweiten Elektrode angeordnet ist, wobei die zweite Elektrode des Annäherungssensors als flexibles Element, insbesondere als Leitgummi ausgebildet ist. Durch diese Maßnahme gelingt es, die Herstellungskosten zu verringern, weil auf ein zeitintensives Löten verzichtet werden kann. Die Verarbeitungstemperatur bei der Anordnung eines adhäsiven Stoffs ist so gering, dass eine Beschädigung der Elektroden des Annäherungssensors und der Leiterplatte verhindert werden kann. Ebenfalls wird bei der Verwendung von adhäsiven Stoffen der Herstellungsprozess beschleunigt, weil in Abhängigkeit von den Eigenschaften des adhäsiven Stoffs ein Abkühlen des adhäsiven Stoffs entweder gar nicht notwendig ist oder im Vergleich zu thermischen Fügeprozessen schneller erfolgt. Es hat sich bei dem erfindungsgemäßen Türgriff ebenfalls gezeigt, dass Feuchtigkeit in den Aufnahmeraum gelingen kann, insbesondere dann, wenn der Aufnahmeraum gegenüber der Umwelt undicht ausgestaltet ist. Durch die Anordnung eines adhäsiven Stoffs wird aber in vorteilhafterweise verhindert, dass Korrosion aufgrund von eintretender Feuchtigkeit in den Aufnahmeraum zwischen den beiden Elektroden auftritt, weil eine Korrosion aufgrund der Eigenschaften des adhäsiven Stoffs ausgeschlossen ist. Das als flexibles Element ausgebildete Leitgummi weist weiterhin den Vorteil auf, dass aufgrund seiner Flexibilität Toleranzen ausgeglichen werden können, wenn dieses mit der Leiterplatte in dem Behälter angeordnet wird. Dabei wird das Leitgummi zwischen einer Wandung des Behälters oder einer Wandung des Gehäuses des Türgriffs und der ersten Elektrode des Annäherungssensors komprimiert. Gleichzeitig kann die Annäherung des Benutzers weiterhin erfasst werden. Vorzugsweise ist das Leitgummi mit Kohlenstoff versetzt, um dessen Leitfähigkeit zu verbessern. Alternativ ist es ebenfalls möglich anstatt des Leitgummis einen Schaumstoff zu verwenden, welcher vorzugsweise mit Kohlenstoff versetzt ist.

Nach einer bevorzugten Ausführungsform der Erfindung ist vorgesehen, dass die zweite Elektrode des Annäherungssensors zumindest teilweise außerhalb des Behälters angeordnet ist.
Da sich die Elektrode außerhalb des Behälters befindet, kann diese nachträglich noch vom Werker in ihrer Form verändert werden und an die konstruktive Ausgestaltung des Gehäuses des Türgriffs angepasst werden. Somit kann der Behälter in Türgriffe eingesetzt werden, die sich in ihrer konstruktiven Form, insbesondere in der konstruktiven Ausgestaltung des Aufnahmeraums, unterscheiden. Die Anzahl der Varianten für den Behälter aufweisend den Annäherungssensor kann folglich vermindert werden. Dadurch werden die Herstellungskosten des Türgriffs deutlich verringert.
Nach einer alternativen Ausführungsform der Erfindung ist vorgesehen, dass die zweite Elektrode des Annäherungssensors vollständig innerhalb des Behälters angeordnet ist. Der Vorteil besteht darin, dass die zweite Elektrode vor äußeren Einflüssen geschützt ist. Des Weiteren kann der Behälter als separates Teil gefertigt werden und unkompliziert in den Aufnahmeraum des Türgriffs eingeschoben werden.

Nach einer bevorzugten Ausführungsform der Erfindung ist vorgesehen, dass die zweite Elektrode des Annäherungssensors als u-förmiges Metallteil ausgebildet ist. Das u-förmige Metallteil kann gebogen werden und kann folglich an den zu Verfügung stehenden Bauraum innerhalb des Aufnahmeraums oder des Behälters angepasst werden. Dadurch ist ein Toleranzausgleich zwischen dem u-förmigen Bauteil und einer Wandung des Aufnahmeraums oder des Behälters einfach durchzuführen. Vorzugsweise ist das Metallteil als Blech ausgebildet, das flexible und biegsame Eigenschaften aufweist.
Sehr einfach und kostengünstig ist die Montage der zweiten Elektrode, wenn mindestens eine Oberfläche der zweiten Elektrode als selbstklebende Oberfläche ausgebildet ist.
Sehr einfach ist die Montage der Elektronik, insbesondere der Leiterplatte, wenn der Aufnahmeraum des Türgriffs mindestens eine Öffnung aufweist, wobei der Aufnahmeraum undicht gegenüber der Umwelt ausgebildet ist.
Es wird im Aufnahmeraum auf Vergussmasse verzichtet, so dass die Herstellungskosten des Türgriffs gesenkt werden. Des Weiteren wird das Gesamtgewicht des Türgriffs verringert, wenn sich ein Hohlraum innerhalb des Türgriffs befindet. Folglich werden auch die Emissionen des Kraftfahrzeugs verringert.
Nach einer bevorzugten Ausführungsform der Erfindung ist vorgesehen, dass zumindest die erste Elektrode des Annäherungssensors und die Leiterplatte innerhalb des Behälters in einer Vergussmasse dichtend gegenüber dem Aufnahmeraum angeordnet sind.

Dies ist besonders vorteilhaft, wenn innerhalb des Aufnahmeraums sich Staub und/oder Feuchtigkeit bildet, welche die Leiterplatte in ihrer Funktion negativ beeinflusst. Folglich kann eine Beschädigung der Elektrode und der Leiterplatte durch Korrosion ausgeschlossen werden. Dies ist besonders der Fall, wenn der Türgriff, insbesondere der Aufnahmeraum undicht gegenüber der Umwelt ausgestaltet ist.

Das Einfüllen der Vergussmasse in den Behälter wird in vorteilhafterweise vereinfacht, wenn die Vergussmasse eine Wandung des Behälters bildet.

Die Erzeugung eines durch den Annäherungssensor erzeugten elektrischen Felds wird weiter verbessert, wenn der adhäsive Stoff leitfähig ausgebildet ist,

Nach einer bevorzugten Ausführungsform der Erfindung ist vorgesehen, dass ein erster kapazitiver Annäherungssensor und ein zweiter kapazitiver Annäherungssensor auf der Leiterplatte angeordnet sind, wobei zwischen der ersten Elektrode und der zweiten Elektrode des jeweiligen Annäherungssensors ein adhäsiver Stoff zur Verbindung der jeweiligen ersten Elektrode mit der jeweiligen zweiten Elektrode angeordnet ist.
Dies bietet den Vorteil, dass die Komplexität des Türgriffs erweitert wird und weitere Funktionen betreffend das Kraftfahrzeug bedient werden können.

Sehr komfortable ist der Türgriff für den Benutzer ausgebildet, wenn der erste kapazitive Annäherungssensor als Entriegelungssensor zum Entriegeln einer Kraftfahrzeugtür ausgebildet ist und der zweite kapazitive Annäherungssensor als Verriegelungssensor zum Verriegeln der Kraftfahrzeugtür ausgebildet ist. Wenn der Benutzer die entsprechenden Annäherungssensoren benutzt, wird der Entriegelungsvorgang bzw. der Verriegelungsvorgang von Türen des Kraftfahrzeugs eingeleitet.

Sehr einfach und komfortabel ist die Bedienung des Türgriffs, wenn der Türgriff eine Öffnung aufweist, in der ein Abschnitt des Behälters zumindest teilweise sichtbar für einen Benutzer angeordnet ist, wobei der Abschnitt als Betätigungsoberfläche des Entriegelungssensors oder Verriegelungssensors dient.

Die Erfindung wird anhand eines Ausführungsbeispiels näher beschrieben. Die Figuren zeigen:
- Figur 1: ein Fahrzeug aufweisend einen erfindungsgemäßen Türgriff, und
- Figur 2: der erfindungsgemäße Türgriff schematisch dargestellt in einer Schnittansicht von oben.

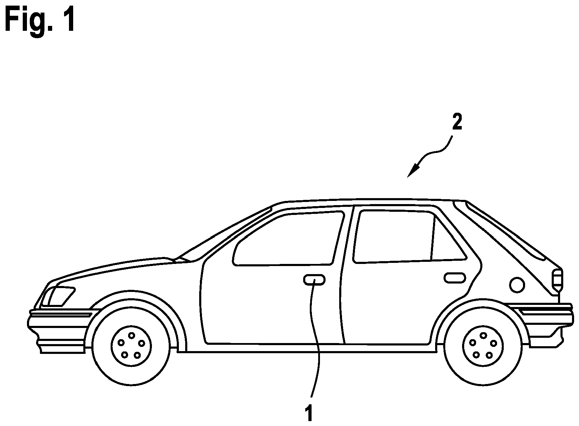

In der Figur 1 ist ein Türgriff 1 für ein Kraftfahrzeug 2 dargestellt, welcher eine Elektronik aufweist, die zur Erfassung einer Annäherung eines Benutzers ausgebildet ist.

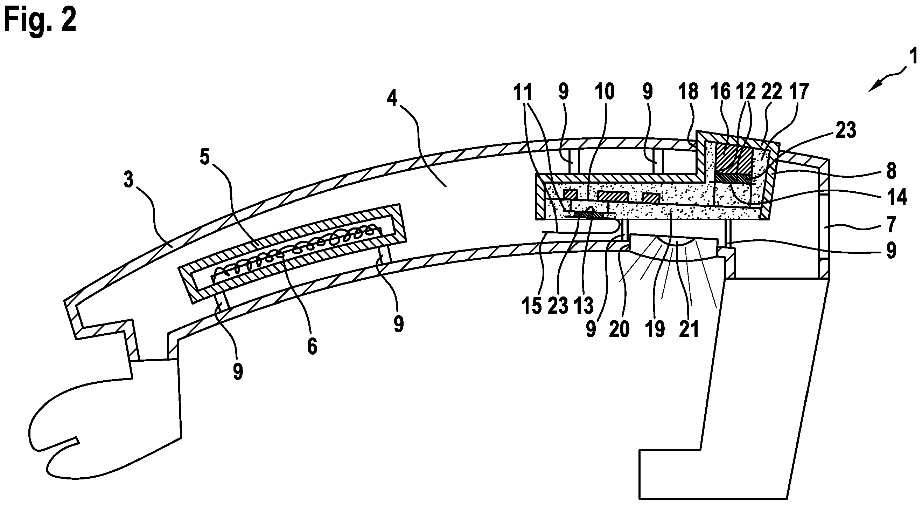

Der in der Figur 2 näher visualisierte Türgriff 1 weist ein Gehäuse 2 auf. Der Türgriff 1 umfasst einen im Wesentlichen durch das Gehäuse 3 gebildeten Aufnahmeraum 4, in welchem eine in einem Container 5 angeordnete Antenne 6 aufgenommen ist. Der Türgriff 1 weist an seinem ersten Ende eine Öffnung 7 auf, welche durch einen nicht näher dargestellten Stopfen verschließbar ist. Wenn der Stopfen in die Öffnung 7 angeordnet wird, ist die Öffnung 7 undicht verschlossen, so dass Feuchtigkeit in den Aufnahmeraum 4 eintreten kann. Alternativ könnte man den Stopfen mit einem elastischen Dichtelement, wie beispielsweise einen O-Ring versehen, um den Aufnahmeraum 4 gegenüber Staub und Feuchtigkeit abzudichten. Innerhalb des Aufnahmeraums 4 befindet sich ein Behälter 8, welcher wie auch der Container 5 bei der Montage durch die Öffnung 7 hindurchgeführt wird. Der Behälter 8 und der Container 5 wird mit Hilfe von Rippen 9, welche einteilig mit dem Gehäuse 3 des Türgriffs 1 ausgebildet sind, formschlüssig verbunden. Eine Leiterplatte 10 dient zur Aufnahme eines ersten kapazitiven Annäherungssensors 11 und eines zweiten kapazitiven Annäherungssensors 12, wobei die Annäherungssensoren 11, 12 zur Erfassung der Annäherung eines Benutzers dienen. Der erste kapazitive Annäherungssensor 11 ist als Entriegelungssensor zum Entriegeln einer Kraftfahrzeugtür ausgebildet und der zweite kapazitive Annäherungssensor 12 als Verriegelungssensor zum Verriegeln der Kraftfahrzeugtür ausgebildet.

Es ist alternativ ebenfalls denkbar, lediglich einen Annäherungssensor oder mehr als zwei Annäherungssensoren innerhalb des Aufnahmeraums, insbesondere innerhalb des Behälters 8 anzuordnen. Die Annäherungssensoren 11, 12 sind auf der Leiterplatte 10 angeordnet, welche sich innerhalb des Behälters 8 befindet. Sowohl der erste Annäherungssensor 11 als auch der zweite Annäherungssensor 12 umfassen jeweils eine erste Elektrode 13, 14 und eine zweite Elektrode 15, 16. Zwischen der ersten Elektrode 13, 14 und der zweiten Elektrode 15, 16 des ersten Annäherungssensors 11 bzw. zweiten Annäherungssensors 12 ist ein adhäsiver Stoff 23 zur Verbindung der ersten Elektrode 13, 14 und der zweiten Elektrode 15, 16 angeordnet. Bei diesem adhäsiven Stoff 23 kann es sich beispielsweise um einen Klebstoff handeln, welcher die erste Elektrode 13, 14 und die zweite Elektrode 15, 16 des jeweiligen Annäherungssensors 11, 12 stoffschlüssig miteinander verbindet. Im Ergebnis sind die erste Elektrode 13, 14 und die zweite Elektrode 15, 16 des kapazitiven Annäherungssensors 11, 12 kapazitiv gekoppelt.

Wie in der Figur 2 gezeigt ist, befindet sich die erste Elektrode 13, 14 geschützt innerhalb des Behälters 8. Die erste Elektrode 13, 14 ist mit der Leiterplatte 10 leitend verbunden und ist Bestandteil des jeweiligen Annäherungssensors 11, 12. Im vorliegenden Ausführungsbeispiel ist die als u-förmiges Metallteil, insbesondere als u-förmiges Blech, ausgebildete zweite Elektrode 15 des ersten Annäherungssensors 11 zumindest teilweise außerhalb des Behälters 8 angeordnet. Um die zweite Elektrode 15 des ersten Annäherungssensors 11 so nah wie möglich an eine Wandung des Gehäuses 3 anzuordnen, wird die Elektrode 15 in Abhängigkeit von der Größe des Aufnahmeraums 4 und der konstruktiven Ausgestaltung des Gehäuses 3 entsprechend gebogen. Im vorliegenden Ausführungsbeispiel weist der Türgriff 1 eine Ausnehmung 20 auf, in welcher eine Beleuchtungseinheit 21 angeordnet ist. Aufgrund dieser Anordnung muss die Elektrode 15 des ersten Annäherungssensors 11 dementsprechend ausgerichtet und gebogen werden.

Somit wird eine außerhalb des Türgriffs 1 von dem kapazitiven Annäherungssensors 11 erzeugte Erfassungszone hinsichtlich der Erkennung einer annähernden Person weiter verbessert. Im vorliegenden Ausführungsbeispiel ist die als flexibles Element ausgebildete zweite Elektrode 16 des zweiten Annäherungssensors 12 vollständig innerhalb des Behälters 8 angeordnet. Die als Leitgummi ausgebildete zweite Elektrode 16 ist ebenfalls mittels eines als adhäsiven Stoffs 23 ausgebildeten Klebstoffs mit der ersten Elektrode 14 stoffschlüssig verbunden. Das vorzugsweise mit Kohlenstoff versetzte Leitgummi weist auf einer Oberfläche eine selbstklebende Schicht auf, wobei die selbstklebende Schicht mit einer Schutzfolie zunächst überdeckt ist. Ein Werker entfernt die auf der selbstklebenden Schicht angeordnete Schutzfolie und kann so das Leitgummi sehr einfach montieren, insbesondere auf die erste Elektrode 14 aufkleben. Vorzugsweise wird ein elastisches oder viskoses "Acrylic Foam" Klebeband als adhäsiver Stoff verwendet. Das elastische "Acrylic Foam" Klebeband zeichnet sich dadurch aus, dass es die Elektroden 13, 15 bzw. 14, 16 spannungsfrei verklebt. Das viskose "Acrylic Foam" Klebeband kompensiert Oberflächenunregelmäßigkeiten der Elektroden 13, 15 bzw. 14, 16 beim Kleben dieser. Alternativ ist es ebenfalls möglich anstatt des Leitgummis einen Schaumstoff zu verwenden, welcher vorzugsweise mit Kohlenstoff versetzt ist. Der Schaumstoff kann dabei ebenfalls mit einem elastischen oder viskosen "Acrylic Foam" Klebeband versehen werden.

Wie in der Figur 2 zu erkennen ist, umfasst der Behälter 8 eine Kammer 17, in welcher das Leitgummi angeordnet ist. Diese Kammer 17 steht aus dem Gehäuse 3 durch eine weitere Öffnung 18 heraus, in der ein Abschnitt des Behälters 8 zumindest teilweise sichtbar für einen Benutzer angeordnet ist, wobei der Abschnitt als Betätigungsoberfläche für den Verriegelungssensor, alternativ den Entriegelungssensor, dient. Alternativ kann dieser Abschnitt des Behälters 8, insbesondere die Wandung des Behälters 8 in diesem Abschnitt auch flächenbündig mit der äußeren Oberfläche des Gehäuses 3 ausgebildet sein. Ebenfalls ist es denkbar, dass dieser Abschnitt des Behälters 8, insbesondere die Wandung des Behälters 8 in diesem Abschnitt auch zurückversetzt angeordnet sein kann und eine Betätigungsmulde bildet.

Bei dem hier unter anderem verwendeten Behälter 8, der Leiterplatte 10, und dem Gehäuse 3 des Türgriffs 1 handelt es sich um Massenartikel, die eine gewisse Maßtoleranz aufweisen. Die Kammer 17 weist eine innere Wandung 22 auf. Zwischen der inneren Wandung 22 der Kammer 17, welche zu dem Abschnitt der Betätigungsoberfläche des zweiten Annäherungssensors 12 gehört, und der ersten Elektrode 14 des zweiten Annäherungssensors 12 befindet sich ein Spalt. Das Leitgummi sollte stets an der inneren Wandung 22 des Behälters 8 anliegen, um eine einwandfreie Funktion des zweiten kapazitiven Annäherungssensors 12 zu gewährleisten. Daher ist die Höhe des Leitgummis größer als die Höhe des zur Verfügung stehenden Spalts. Wenn das Leitgummi zu groß ist, kann es durch seine flexible Eigenschaften komprimiert werden und trotzdem in den Spalt eingesetzt werden. Dadurch können Toleranzprobleme, welche durch andere Bauteile des Türgriffs 1 entstehen ausgeglichen werden. Somit gelingt es durch eine Überdimensionierung des Leitgummis, einen Luftspalt zwischen dem Leitgummi und der inneren Wandung 22 zu verhindern.

Der Aufnahmeraum 4 des Türgriffs weist, wie bereits zuvor beschrieben, Öffnungen 7, 18 auf. Um das Gewicht und die Herstellungskosten des Türgriffs zu reduzieren, wird auf ein Einfüllen von Vergussmasse in den Aufnahmeraum 4 verzichtet. Folglich kann unter Umständen Feuchtigkeit und Staub in den Aufnahmeraum des Türgriffs 1 eindringen. Um die Leiterplatte 10 gegenüber der in den Aufnahmeraum 4 eintretenden Feuchtigkeit zu schützen, wird der Behälter 8 nach der Montage der Leiterplatte 10 und der Annäherungssensoren 11, 12 abschließend mit einer Vergussmasse 19 vergossen. Damit sind die Elektroden 14, 15, 16 der Annäherungssensoren 11, 12 und die Leiterplatte 10 innerhalb des Behälters 8 in der Vergussmasse 19 dichtend gegenüber dem Aufnahmeraum 4 angeordnet und vor Korrosion geschützt. Die erste Elektrode 13 des ersten Annäherungssensors 11, welche teilweise außerhalb des Behälters 8 angeordnet ist und in den Aufnahmeraum 4 hineinragt, wird daher aus einem korrosionsbeständigen Material ausgebildet. Die Elektroden 14, 15, 16 können auch aus einem korrosionsunbeständigen Material ausgebildet sein, weil diese in der Vergussmasse 19 angeordnet sind. Die Vergussmasse 19 bildet eine Wandung des Behälters 8, so dass auch für die Herstellung des Behälters 8 Material eingespart wird.

### Bezugszeichenliste

- 1: Türgriff
- 2: Kraftfahrzeug
- 3: Gehäuse
- 4: Aufnahmeraum
- 5: Container
- 6: Antenne
- 7: Öffnung
- 8: Behälter
- 9: Rippen
- 10: Leiterplatte
- 11: erster Annäherungssensor
- 12: zweiter Annäherungssensor
- 13: erste Elektrode des ersten Annäherungssensors 11
- 14: erste Elektrode des zweiten Annäherungssensors 12
- 15: zweite Elektrode des ersten Annäherungssensors 11
- 16: zweite Elektrode des zweiten Annäherungssensors 12
- 17: Kammer
- 18: Öffnung
- 19: Vergussmasse
- 20: Ausnehmung
- 21: Beleuchtungseinheit
- 22: innere Wandung
- 23: adhäsiver Stoff

## Patentansprüche

1. Türgriff (1) für ein Kraftfahrzeug (2) mit einem Aufnahmeraum (4) aufweisend einen innerhalb des Aufnahmeraums (4) angeordneten Behälter (8) zur Aufnahme einer Leiterplatte (10), wobei die Leiterplatte (10) mindestens einen kapazitiven Annäherungssensor (11, 12) zur Erfassung der Annäherung eines Benutzers umfasst,
**dadurch gekennzeichnet, dass**
der kapazitive Annährungssensor (11, 12) eine erste Elektrode (13, 14) und ein zweite Elektrode (15, 16) aufweist,
wobei zwischen der ersten Elektrode (13, 14) und der zweiten Elektrode (15, 16) des Annäherungssensors (11, 12) ein adhäsiver Stoff (23) zur Verbindung der ersten Elektrode (13, 14) mit der zweiten Elektrode (15, 16) angeordnet ist, wobei die zweite Elektrode (15, 16) des Annäherungssensors (11, 12) als flexibles Element, insbesondere als Leitgummi ausgebildet ist.

2. Türgriff (1) nach Anspruch 1, **dadurch gekennzeichnet, dass** die zweite Elektrode (15, 16) des Annäherungssensors (11, 12) zumindest teilweise außerhalb des Behälters (8) angeordnet ist.

3. Türgriff (1) nach Anspruch 1, **dadurch gekennzeichnet, dass** die zweite Elektrode (15, 16) des Annäherungssensors (11, 12) vollständig innerhalb des Behälters (8) angeordnet ist.

4. Türgriff (1) nach einem der Ansprüche 1 bis 3, **dadurch gekennzeichnet, dass** die zweite Elektrode (15, 16) des Annäherungssensors (11, 12) als u-förmiges Metallteil ausgebildet ist.

5. Türgriff (1) nach einem der Ansprüche 1 bis 5, **dadurch gekennzeichnet, dass** mindestens eine Oberfläche der zweiten Elektrode (15, 16) als selbstklebende Oberfläche ausgebildet ist.

6. Türgriff (1) nach einem der Ansprüche 1 bis 5, **dadurch gekennzeichnet, dass** der Aufnahmeraum (4) des Türgriffs (1) mindestens eine Öffnung (7, 18) aufweist, wobei der Aufnahmeraum (4) undicht gegenüber der Umwelt ausgebildet ist.

7. Türgriff (1) nach einem der Ansprüche 1 bis 6, **dadurch gekennzeichnet, dass** zumindest die erste Elektrode (13, 14) des Annäherungssensors (11, 12) und die Leiterplatte (10) innerhalb des Behälters (8) in einer Vergussmasse (19) dichtend gegenüber dem Aufnahmeraum (4) angeordnet sind.

8. Türgriff (1) nach einem der Ansprüche 1 bis 7, **dadurch gekennzeichnet, dass** die Vergussmasse (19) eine Wandung des Behälters (8) bildet.

9. Türgriff (1) nach einem der Ansprüche 1 bis 8, **dadurch gekennzeichnet, dass** der adhäsive Stoff (23) leitfähig ausgebildet ist, insbesondere Kohlenstoff umfasst.

10. Türgriff (1) nach einem der Ansprüche 1 bis 9, **dadurch gekennzeichnet, dass** ein erster kapazitiver Annäherungssensor (11) und ein zweiter kapazitiver Annäherungssensor (12) auf der Leiterplatte (10) angeordnet sind, wobei zwischen der ersten Elektrode (13, 14) und der zweiten Elektrode (15, 16) des jeweiligen Annäherungssensors (11, 12) ein adhäsiver Stoff (23) zur Verbindung der jeweiligen ersten Elektrode (13, 14) mit der jeweiligen zweiten Elektrode (15, 16) angeordnet ist.

11. Türgriff (1) nach einem der Ansprüche 1 bis 10, **dadurch gekennzeichnet, dass** der erste kapazitive Annäherungssensor (11) als Entriegelungssensor zum Entriegeln einer Kraftfahrzeugtür ausgebildet ist und der zweite kapazitive Annäherungssensor (12) als Verriegelungssensor zum Verriegeln der Kraftfahrzeugtür ausgebildet ist.

12. Türgriff (1) nach einem der Ansprüche 1 bis 11, **dadurch gekennzeichnet, dass** der Türgriff (1) eine Öffnung (18) aufweist, in der ein Abschnitt des Behälters (8) zumindest teilweise sichtbar für einen Benutzer angeordnet ist, wobei der Abschnitt als Betätigungsoberfläche des Entriegelungssensors oder Verriegelungssensors dient.

## Claims

1. A door handle (1) for a motor vehicle (2) with a receiving space (4) comprising a container (8) arranged within the receiving space (4) for receiving a circuit board (10), wherein the circuit board (10) comprises at least one capacitive proximity sensor (11, 12) for recording the approach of a user
**characterised in that**
the capacitive sensor (11, 12) comprises a first electrode (13, 14) and a second electrode (15, 16),
wherein between the first electrode (13, 14) and the second electrode (15, 16) of the proximity sensor (11, 12) an adhesive material (23) for connecting the first electrode (13, 14) to the second electrode (15, 16) is arranged, wherein the second electrode (15. 16) of the proximity sensor (11, 12) is designed as a flexible element, more particularly as a conductive rubber.

2. The door handle (1) according to claim 1 **characterised in that** the second electrode (15, 16) of the proximity sensor (11, 12) is arranged at least partially outside the container (8).

3. The door handle (1) according to claim 1 **characterised, in that** the second electrode (15, 16) of the proximity sensor (11, 12) is arranged completely within the container (8).

4. The door handle (1) according to any one of claims 1 to 3 **characterised in that** the second electrode (15, 16) of the proximity sensor (11, 12) is designed in the form of a U-shaped metal component.

5. The door handle (1) according to any one of claims 1 to 5 **characterised in that** the at least one surface of the second electrode (15, 16) is designed as a self-adhesive surface.

6. The door handle (1) according to any one of claims 1 to 5 **characterised in that** the receiving space (4) of the door handle (1) comprises at least one opening (7, 18) wherein the receiving space (4) is not sealed off from the environment.

7. The door handle (1) according to any one of claims 1 to 6 **characterised in that** at least the first electrode (13, 14) of the proximity sensor (11, 12) and the circuits board (10) within the container (8) are arranged in a sealing compound (19) sealed off from the receiving space (4).

8. The door handle (1) according to any one of claims 1 to 7, **characterised in that** the sealing compound (19) forms a wall of the container (8).

9. The door handle (1) according to any one of claims 1 to 8 **characterised in that** the adhesive material (23) is conductive, in particular contains carbon.

10. The door handle (1) according to any one of claims 1 to 9 **characterised in that** a first capacitive proximity sensor (11) and a second capacitive proximity sensor (12) are arranged on the circuit board (10), wherein arranged between the first electrode (13, 14) and the second electrode (15, 16) of the respective proximity sensor (11, 12) is an adhesive material (23) for connecting the respective first electrode (13, 14) with the respective second electrode (15, 16).

11. The door handle (1) according to any one of claims 1 to 10 **characterised in that** the first capacitive proximity sensor (11) is designed as an unlocking sensor for unlocking a motor vehicle door and the second capacitive proximity sensor (12) is designed as a locking sensor for locking the motor vehicle door.

12. The door handle (1) according to any one of claims 1 to 11 **characterised in that** the door handle (1) comprise an opening (18) in which a section of the container (8) is arranged so that it is at least partially visible to a user, wherein the section serves as an operating surface of the unlocking senor or the locking sensor.

## Revendications

1. Poignée (1) pour un véhicule automobile (2) comportant un espace de réceptacle (4) présentant un contenant (8) disposé à l'intérieur de l'espace de réceptacle (4) pour recevoir une plaquette de circuit imprimé (10), dans laquelle la plaquette de circuit imprimé (10) comprend au moins un détecteur de proximité capacitif (11, 12) pour détecter la proximité d'un utilisateur,
**caractérisé en ce que**
le détecteur de proximité capacitif (11, 12) présente une première électrode (13, 14) et une deuxième électrode (15, 16),
dans laquelle entre la première électrode (13, 14) et la deuxième électrode (15, 16) du détecteur de proximité (11, 12) une substance adhésive (23) pour relier la première électrode (13, 14) avec la deuxième électrode (15, 16) est disposée, dans laquelle la deuxième électrode (15, 16) du détecteur de proximité (11, 12) est conçue comme un élément flexible, notamment comme un caoutchouc conducteur.

2. Poignée (1) selon la revendication 1, **caractérisée en ce que** la deuxième électrode (15, 16) du détecteur de proximité (11, 12) est disposée au moins partiellement à l'extérieur du récipient (8).

3. Poignée (1) selon la revendication 1, **caractérisé en ce que** la deuxième électrode (15, 16) du détecteur de proximité (11, 12) est disposée complètement à l'intérieur du contenant (8).

4. Poignée (1) selon une des revendications 1 à 3, **caractérisée en ce que** la deuxième électrode (15, 16) du détecteur de proximité (11, 12) est conçue comme une pièce métallique en forme de U.

5. Poignée (1) selon une des revendications 1 à 5, **caractérisée en ce qu'**au moins une surface de la deuxième électrode (15, 16) est conçue comme une surface autocollante.

6. Poignée (1) selon une des revendications 1 à 5, **caractérisée en ce que** l'espace de réceptacle (4) de la poignée (1) présente au moins une ouverture (7, 18), dans laquelle l'espace de réceptacle (4) est conçu de manière non étanche par rapport à l'environnement ambiant.

7. Poignée (1) selon une des revendications 1 à 6, **caractérisée en ce que** au moins la première électrode (13, 14) du détecteur de proximité (11, 12) et la plaquette de circuit imprimé (10) à l'intérieur de contenant (8) sont disposées dans une masse de scellement (19) à action étanche par rapport à l'espace de réceptacle (4).

8. Poignée (1) selon une des revendications 1 à 7, **caractérisé en ce que** la masse de scellement (19) forme une paroi du contenant (8).

9. Poignée (1) selon une des revendications 1 à 8, **caractérisée en ce que** la substance adhésive (23) est conçue de manière conductrice, notamment comprend du carbone.

10. Poignée (1) selon une des revendications 1 à 9, **caractérisée en ce que** un premier détecteur de proximité capacitif (11) et un deuxième détecteur de proximité capacitif (12) sont disposés sur la plaquette de circuit imprimé (10), dans laquelle entre la première électrode (13, 14) et la deuxième électrode (15, 16) du détecteur de proximité respectif (11, 12) est disposée une substance adhésive (23) pour relier la première électrode respective (13, 14) à la deuxième électrode respective (15, 16).

11. Poignée (1) selon une des revendications 1 à 10, **caractérisée en ce que** le premier détecteur de capacité capacitif (11) est conçu comme un capteur de déverrouillage pour déverrouiller une porte de véhicule automobile et le deuxième détecteur de proximité capacitif (12) est conçu comme un capteur de verrouillage pour verrouiller la porte de véhicule automobile.

12. Poignée (1) selon une des revendications 1 à 11, **caractérisée en ce que** la poignée (1) présente une ouverture (18), dans laquelle une portion du contenant (8) est disposée de manière au moins partiellement visible pour un utilisateur, dans laquelle la portion sert de surface d'actionnement du capteur de déverrouillage ou capteur de verrouillage.
